# FASCICULE DE BREVET EUROPEEN

(11) **EP 3 156 361 B1**
(45) Date de publication et mention de la délivrance du brevet: **08.11.2017**
(21) Numéro de dépôt: 16190126.9
(22) Date de dépôt: 22.09.2016
(51) Int. Cl.: B81B 7/00

(54) **MICROSYSTÈME ÉLECTROMÉCANIQUE COMPRENANT UNE COUCHE DE DECOUPLAGE ET PROCÉDÉ DE FABRICATION**
ELEKTROMECHANISCHES MIKROSYSTEM MIT ENTKOPPELSCHICHT UND SEIN HERSTELLUNGSVERFAHREN
ELECTROMECHANICAL MICROSYSTEM HAVING DECOUPLING LAYER AND MANUFACTURING METHOD

(30) Priorité: 16.10.2015 FR 1502178
(43) Date de publication de la demande: 19.04.2017
(73) Titulaire: Thales, 92400 Courbevoie (FR)
(72) Inventeur: FILHOL, Fabien, 26120 Chabeuil (FR); LEFORT, Pierre-Olivier, 26000 VALENCE (FR); LEVERRIER, Bertrand, 26120 MONTELIER (FR); QUER, Régis, 07130 SAINT PERAY (FR); CHAUMET, Bernard, 86100 CHATELLERAULT (FR)
(74) Mandataire: Derval, Estelle

(56) Documents cités:
- EP-A1- 2 447 209
- DE-A1- 4 107 658
- US-A1- 2015 181 697

## Description

La présente invention se rapporte aux microsystèmes électromécaniques appelés MEMS en référence à l'acronyme désignant l'expression anglo-saxonne « Micromelectromechanical systems » tels que des microcapteurs ou des microactuateurs. L'invention se rapporte aux microsystèmes micro-usinés, du type en silicium (c'est-à-dire comprenant une structure mécanique active réalisée dans une couche de silicium monocristallin). La structure active est essentiellement planaire dans la plaque dans laquelle elle est gravée. Le document DE 41 07 658 A1 décrit un tel microsystème. Ce microsystème comprend une couche active en silicium monocristallin, ladite couche active comprenant une structure active (soit une masse mobile), un premier capot et un deuxième capot délimitant une cavité autour de la structure active, la couche active étant interposée entre le premier capot et le deuxième capot, le deuxième capot comprenant une unique couche en silicium monocristallin et un élément de report destiné à être fixé à un support. La fabrication de ces microsystèmes électromécaniques micro-usinés, utilise des techniques de micro-usinage collectif, gravure, dépôts, dopage, etc., semblables à celles qui sont utilisées pour la fabrication de circuits intégrés électroniques, permettant de faibles coûts de production. L'invention se rapporte plus particulièrement aux microcapteurs, permettant de mesurer une grandeur physique telle qu'une vitesse angulaire (gyromètre), un déplacement angulaire (gyroscope), une accélération (accéléromètre), ou une pression (capteur de pression). Par structure sensible d'un capteur MEMS, on entend une partie déformable du MEMS dont la déformation varie sous l'effet d'une grandeur physique (accélération, vitesse angulaire, pression) qui est la grandeur physique à mesurer. La structure active peut également se déformer sous l'effet d'un signal électrique, lorsqu'elle comporte des micro-actionneurs. La structure active a typiquement des dimensions allant de quelques micromètres à quelques millimètres.

Selon un mode de réalisation fréquent, la structure sensible d'un capteur MEMS est mise en vibration de façon à observer l'effet de la grandeur physique à mesurer sur la fréquence de résonance ou l'amplitude de vibration. En général, la performance d'un tel capteur dépend du facteur de qualité du ou des modes de vibration utiles de la structure sensible. Les matériaux monocristallins, tels que le quartz ou le silicium permettent de fabriquer des micro-résonateurs avec des facteurs de qualité élevés.

Le conditionnement comprend les moyens qui permettent de manipuler ces ME MS pendant l'intégration dans les produits sans risquer de les dégrader et en limitant l'impact de l'environnement externe sur leurs structures sensibles, notamment pour les protéger de l'empoussièrement.

D'autre part, pour obtenir un facteur de qualité élevé, il est nécessaire de mettre la structure active sous un vide plus ou moins poussé. Il est donc encapsulé dans une enceinte hermétique, qui peut être intégrée à la puce MEMS ou qui peut être réalisée par un boitier dans lequel la puce MEMS est rapportée, et au sein de laquelle une atmosphère à pression réduite est réalisée. Il est fréquent qu'une pression inférieure à 10⁻² hPa soit nécessaire au bon fonctionnement. Les technologies de report du MEMS dans son boitier doivent donc être compatibles avec la mise sous vide, ce qui conduit à éviter les matériaux susceptibles de dégazer.

Le conditionnement doit aussi veiller à maîtriser la position relative de la structure sensible sur son support. Il est connu d'utiliser des technologies de collage ou de brasage pour fixer les MEMS sur un support. Un collage ou un brasage est réalisé sur tout ou partie d'une face de la structure en utilisant des colles dites souples à base de silicone ou des brasages dits raides à base d'un mélange or/étain.

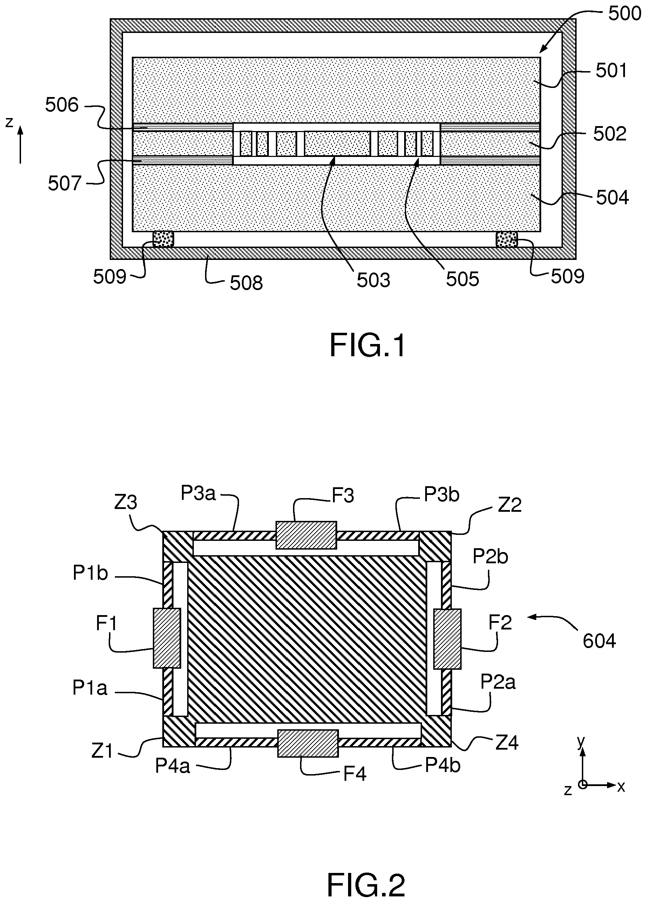

La figure 1 illustre une première architecture d'un dispositif électromécanique comprenant une puce MEMS 500 fixée sur un support 508. La puce MEMS comprenant un empilement, réalisé selon une direction d'empilement z, d'une pluralité de couches de silicium comprenant : un substrat 501 en silicium monocristallin, un capot 504 en silicium monocristallin, une couche sensible 502 en silicium monocristallin interposée entre le capot 504 et le substrat 501, ladite couche sensible 502 comprenant une structure sensible 503 déformable. Le capot 504 et le substrat 501 délimitent une cavité 505 autour de la structure active 503.

Les couches de silicium monocristallin 501, 502, 504 sont reliées deux à deux par des couches d'oxyde de silicium 506, 507. La puce MEMS 500 est fixée à un support 508, ici un boitier, au moyen de plots 509 de collage ou de brasage.

L'une des contraintes pouvant affecter les performances du capteur MEMS, à laquelle on s'intéresse particulièrement pour la présente invention, est la limitation de la transmission des contraintes thermomécaniques à évolution lente sur la structure sensible. Les contraintes thermomécaniques sont transmises, à la stucture sensible 503, par les éléments de fixation 509 du capteur. Ces contraintes proviennent typiquement :
- des déformations dans le plan perpendiculaire à la direction d'empilement z, causées par le phénomène d'expansion thermique différentielle entre le matériau du capteur MEMS 500 et le matériau du support 508 ;
- des déformations du support 508 hors de ce plan, causées par exemple, par la fixation du support 508 à un autre élément ;
- du phénomène de fluage dans le matériau employé pour la fixation du capteur MEMS à son support, c'est-à-dire dans les plots de fixation ce qui produit une évolution lente des contraintes.

Une partie de ces déformations est transmise à la structure sensible du capteur MEMS et provoque une dérive du signal de sortie du capteur. Il est possible de modéliser et de compenser une partie de cette dérive, en particulier la dérive due aux variations de température. Par contre il n'est pas possible de compenser la dérive due aux phénomènes de fluage. La conception de microcapteurs performants nécessite d'optimiser l'architecture du report du capteur MEMS de façon à réduire le plus possible la transmission de contraintes thermomécaniques sur l'élément sensible, c'est-à-dire de manière à réaliser un découplage des déformations statiques entre le support et la structure sensible.

Ceci peut en particulier être obtenu par des éléments de fixation souples, par exemple des colles à base de silicone, permettant de fixer le support au capteur MEMS, qui se déforment pour absorber les déformations du support. Toutefois, la surface de collage ou de brasure doit être suffisamment large pour assurer la robustesse de la liaison dans l'environnement applicatif (vibrations, chocs, cycles thermiques). Il s'ensuit qu'il est difficile d'annuler complètement les contraintes causées par la différence entre les coefficients d'expansion thermique du silicium de la puce MEMS et du matériau de collage/brasure. De plus, la performance du capteur peut être sensible aux défauts géométriques du plot de colle/brasure.

Il est aussi connu d'utiliser des technologies de brasage avec différents alliages (par exemple un mélange or/étain) ou de collage rigide pour fixer le capteur MEMS à son support, sur des surfaces plus ou moins importantes du capteur MEMS. Toutefois ces alliages étant beaucoup plus raides qu'un collage souple, ils sont susceptibles de transmettre fortement les contraintes thermomécaniques à l'élément sensible.

Pour pallier les inconvénients précédemment cités, il est connu que des structures de découplage souples peuvent être ajoutées pour réaliser l'interface entre les éléments de fixation (ou plots de fixation) et le capteur MEMS.

La figure 2 illustre une couche de découplage d'un deuxième exemple de microsystème selon l'art antérieur. Ce microsystème est décrit dans la demande de brevet publiée avec la référence EP2447209. Il diffère de celui de la figure 1 par son capot 604, seul élément visible sur la figure 2. La figure 2 représente schématiquement en coupe, le capot 604. Le capot 604 comprend des éléments de F1, F2, F3, F4 par lesquels la puce MEMS est fixée au support 508. Le dispositif comprend donc 4 plots de fixation interposés entre les éléments de fixation respectifs F1 à F4 et le support 508. Les éléments de fixation F1, F2, F3, F4 sont liés aux zones de la couche active Z1 à Z4 qui sont solidaires de la couche sensible 502, par des structures de découplage souples qui sont des poutres flexibles (P1a, P1b, P2a, P2b, P3a, P3b, P4a et P4b) s'étendant selon deux directions orthogonales du plan x, y perpendiculaire à la direction d'empilement z. Les structures de découplage souples ont pour rôle de filtrer les déformations statiques du support pour limiter au maximum la transmission des contraintes mécaniques depuis le support 508 vers la structure sensible 503.

Cette solution permet d'améliorer les performances du découplage statique des contraintes thermomécaniques entre la structure active du capteur MEMS et son support. En revanche, cette solution reste limitée par le fait que la fixation est hyperstatique, c'est-à-dire qu'il y a plus de points de fixation que ce qui est strictement nécessaire pour supprimer tous les degrés de liberté. Malgré le découplage statique réalisé par les poutres de découplage, il reste toujours une partie de la déformation du support qui sera transmise à la structure active.

Un but de l'invention est de concevoir un microsystème électromécanique qui puisse être fixé à un support avec une transmission limitée des contraintes mécaniques depuis le support vers la structure active de la puce MEMS.

A cet effet, l'invention a pour objet un microsystème électromécanique comprenant un assemblage d'une pluralité de couches empilées selon une direction d'empilement comprenant :
- une couche active en silicium monocristallin, ladite couche active comprenant une structure active,
- un premier capot et un deuxième capot délimitant une cavité autour de la structure active, la couche active étant interposée entre le premier capot et le deuxième capot, le deuxième capot comprenant une unique couche en silicium monocristallin.
L'assemblage comprend en outre, une couche de découplage en silicium monocristallin comprenant :
- un élément de report destiné à être fixé à un support,
- un cadre entourant l'élément de report dans le plan de la couche de découplage,
- une structure de découplage mécanique reliant le cadre et la structure de report, la structure de découpage mécanique permettant de relier de façon flexible l'élément de report au cadre.

Le cadre est solidaire de la couche de silicium du deuxième capot et au plus un film d'un matériau est interposé entre ledit cadre et ladite couche de silicium du deuxième capot. Le matériau est du dioxyde de silicium.

Le microsystème électromécanique ainsi formé est une puce MEMS. Un unique élément de report de la puce MEMS est destiné à être fixée à un support. Les structures de découplage permettent de limiter la transmission des contraintes liées à des déformations du support vers la puce MEMS et en particulier vers la structure sensible de la puce MEMS. Il est en effet possible de former une liaison isostatique entre la puce MEMS et son support.

L'élément de report occupe une position centrale, dans un plan perpendiculaire à la direction d'empilement, puisqu'il est entouré par un cadre. L'élément de report est lié au cadre, et par conséquent au reste de la puce MEMS, par les structures de découplage flexibles. Cette architecture permet de limiter les effets des vibrations sur la structure sensible du fait qu'on conserve un certain degré d'équilibre de la structure. De plus, le fait de réaliser les structures de découplage au centre, plutôt qu'en périphérie, conduit à une économie de surface de silicium, ce qui procure également un avantage en termes de coût récurrent de fabrication, car il est possible de fabriquer un plus grand nombre de puces MEMS par wafer.

La réalisation d'une structure de découplage implique de graver une couche de silicium et de libérer la structure formée ce qui a pour effet de laisser passer l'atmosphère ambiante au travers de la couche dans laquelle est réalisée la structure de découplage. Le fait de former l'élément de report et la structure de découplage dans une couche de silicium supplémentaire dédiée différente des couches de silicium des capots, permet d'éviter de compromettre l'encapsulation de la structure active dans la cavité formée autour de cette structure sensible. Cela permet d'éviter de rompre le vide intégré à la cavité formée autour de la structure sensible ou d'éviter d'exposer la structure active à l'empoussièrement tout en plaçant le découpleur mécanique en regard des structures sensibles de la puce MEMS (c'est-à-dire en prévoyant des structures de découplage occupant les mêmes coordonnées que les structures sensibles de la puce MEMS dans un plan perpendiculaire à la direction d'empilement). Or, le fait de placer la structure de découplage en regard des structures sensibles de la puce MEMS permet de garantir un certain équilibre de la structure pour limiter l'effet des vibrations sur la structure active et de conserver la symétrie générale de la structure du capteur ce qui permet d'obtenir un certain degré de symétrie des effets physiques s'appliquant sur la structure active. Ceci est particulièrement important dans le cas où la structure sensible possède des éléments de symétrie résultant d'une architecture différentielle. La puce MEMS est ainsi compatible avec un vide réalisé dans le boitier et un vide intégré à la puce MEMS sans empoussièrement ou dégradation du vide.

L'invention est compatible avec les différentes solutions de brasure et de collage rigide ou souple, ce qui laisse des degrés de liberté au concepteur pour ajuster le découplage dynamique en fonction de l'architecture de la structure active et l'environnement applicatif visé. Par découplage dynamique, on entend la séparation des fréquences des modes propres de vibration de la puce MEMS rapportée sur son support et des fréquences des modes utiles de la structure active.

Comme les structures de découplage sont réalisées directement dans le silicium de la puce MEMS, l'homogénéïté et la compacité de la puce sont préservées et une fabrication collective d'une pluralité de puces selon l'invention est possible. Par ailleurs, les procédés de micro-usinage disponibles pour la réalisation de la structure active et de la structure de découplage ainsi que les procédés pour assembler le capot de silicium avec la couche de découplage permettent de bien maîtriser leurs géométries et d'obtenir des positionnement relatifs précis entre ces structures.

Cela permet de minimiser les contraintes thermiques induites, grâce à l'homogénéité des matériaux autour des interfaces et par l'absence de matériau d'apport autre que le dioxyde de silicium.

Le microsystème selon l'invention comprend avantageusement au moins une des caractéristiques suivantes prises seules ou en combinaison :
- la couche de découplage et le deuxième capot sont assemblés par scellement direct ;
- la structure active, dans un plan perpendiculaire à la direction d'empilement présente, au moins un élément de symétrie et la structure de découplage mécanique présente ledit au moins un élément de symétrie ;
- l'élément de report et la structure de découplage présentent des plans de symétrie parallèles à la direction d'empilement, ces plans de symétrie se coupent selon une droite qui est parallèle à la direction d'empilement et sur laquelle est situé le centre de masse de la partie du microsystème électromécanique qui est reliée à l'élément de report par la structure de découplage. ;
- la structure de découplage mécanique comprend :
   - au moins un premier élément de découplage conçu pour autoriser un déplacement de l'élément de report par rapport au cadre selon une première direction du plan de la couche de découplage mais pour empêcher tout mouvement significatif de l'élément de report par rapport au cadre selon un deuxième direction du plan de la couche de découplage perpendiculaire à la première direction,
   - au moins un deuxième élément de découplage conçu pour autoriser un déplacement de l'élément de report par rapport au cadre selon une troisième direction du plan de la couche de découplage mais pour empêcher tout mouvement significatif de l'élément de report par rapport au cadre selon une quatrième direction du plan de la couche de découplage perpendiculaire à la troisième direction, la troisième direction étant distincte de la première direction ;
- la première direction et la troisième direction sont orthogonales,
- la structure de découplage mécanique comprend deux premiers éléments de découplage disposés de part et d'autre l'élément de report selon la première direction et deux deuxièmes éléments de découplage disposés de part et d'autre de l'élément de report selon la troisième direction ;
- les premiers et deuxièmes éléments de découplage sont des bras de flexion ;
- l'élément de report central est délimité par un polygone comprenant une pluralité de côtés, la structure de découplage comprenant des éléments de liaison reliant le cadre et les côtés respectifs du polygone, chaque élément de liaison comprenant au moins un desdits bras de liaison s'étendant parallèlement audit côté du polygone ;
- le polygone comprend plus de quatre côtés.

L'invention se rapporte également à un dispositif électromécanique comprenant le microsystème électromécanique selon l'invention et un support, la couche de découplage étant fixée audit support uniquement via ledit élément de report.

Avantageusement, une unique surface continue de l'élément de report est fixée audit support.

L'invention se rapporte également à un procédé de fabrication d'un microsystème électromécanique selon l'invention, ledit procédé comprenant une étape de formation de l'assemblage comprenant une étape d'empilement et d'assemblage dans laquelle on empile et on assemble la couche de découplage et la couche de silicium du deuxième capot, de sorte qu'au plus un film d'un matériau est interposé entre la couche de découplage et ladite couche de silicium du deuxième capot, le matériau étant du dioxyde de silicium.

Avantageusement, l'assemblage de la couche de découplage et de la couche de silicium du deuxième capot est réalisé par scellement direct.

Avantageusement, le procédé comprend une étape collective de formation de l'assemblage de la pluralité de couches permettant d'obtenir un assemblage sous forme d'une plaque intégrant une pluralité de microsystèmes électromécaniques et une étape de séparation consistant à découper la plaque de sorte à isoler les microsystèmes électromécaniques.

D'autres caractéristiques et avantages de l'invention apparaîtront à la lecture de la description détaillée qui suit, faite à titre d'exemple non limitatif et en référence aux dessins annexés dans lesquels :
- la figure 1 déjà décrite représente en coupe un microsystème micromécanique selon l'art antérieur, la coupe est représentée selon un plan parallèle à la direction d'empilement de couches constituant le microsystème,
- la figure 2 déjà décrite représente schématiquement en coupe une couche de découplage d'un microsystème de l'art antérieur,
- la figure 3 représente schématiquement un microsystème micromécanique selon l'invention en coupe, selon un plan parallèle à la direction d'empilement,
- les figures 4 et 5 représentent schématiquement en coupe dans des plans perpendiculaires à la direction d'empilement, trois exemples de couches de découplage selon l'invention,
- la figure 6 représente schématiquement les étapes d'un exemple de procédé selon l'invention.

D'une figure à l'autre, les mêmes éléments sont repérés par les mêmes références.

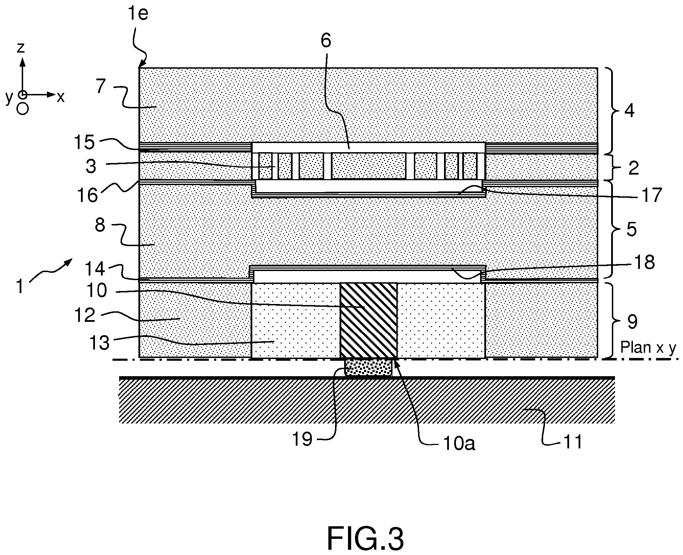

La figure 3 représente schématiquement une vue en coupe d'un microsystème électromécanique ou puce MEMS selon l'invention. La coupe est réalisée dans un plan comprenant la direction d'empilement z.

Le microsystème selon l'invention est par exemple un capteur.

Comme visible sur la figure 3, le microsystème électromécanique 1 ou puce MEMS selon l'invention comprend un assemblage 1e d'une pluralité de couches empilées selon la direction d'empilement z. La pluralité de couches comprend :
- une couche active 2 de silicium monocristallin, ladite couche active 2 comprenant une structure active 3 du microsystème électromécanique 1,
- un premier capot 4 et un deuxième capot 5 délimitant une cavité 6 autour de la structure active 3.

La structure active 3 est micro-usinée dans le plan de la couche de silicium 2. La structure active est une structure mobile, c'est-à-dire librement déformable, par rapport au reste de la couche active 2 et plus particulièrement par rapport à une ou plusieurs zones d'ancrage fixes de la couche active 2.

La couche active 2 est interposée, selon la direction z, entre le premier capot 4 et le deuxième capot 5. Les capots 4 et 5 ont pour fonction de soutenir la couche sensible (ou active) de la puce MEMS et de protéger la structure sensible 3 des poussières et des chocs.

Le premier capot 4 et le deuxième capot 5 comprennent chacun une unique couche de silicium monocristallin 7, 8. Sur la réalisation non limitative de la figure 3, la couche de silicium 7 du premier capot 2 n'est pas oxydée en regard de la structure sensible 3 alors que la couche de silicium 8 du deuxième capot 5 est oxydée en regard de la structure sensible 3. De manière générale, chaque capot 4, 5 est constitué d'une couche de silicium monocristallin oxydée, au moins en regard de la structure sensible, ou d'une couche de silicium pure en regard de la structure sensible 3, c'est-à-dire non oxydée en regard de la structure sensible 3. Sur la réalisation non limitative de la figure 3, une couche de dioxyde de silicium 15, 16 est interposée entre chaque capot 4, 5 et la couche active 2 aux interfaces d'assemblage entre chaque capot et la couche active 2.

L'empilement selon l'invention comprend en outre une couche de découplage 9 en silicium monocristallin comprenant un élément de report 10 destiné à être fixé à un support 11. L'empilement est fixé au support 11 via la couche de découplage 9 uniquement. Sur la réalisation de la figure 3, la couche de découplage 9 est fixée au support 11 uniquement par l'intermédiaire de l'élément de report 10. Autrement dit, seul l'élément de report 10 de la couche de découplage 9 est fixé au support 11.

Sur la réalisation préférentielle de la figure 3, l'empilement est fixé au support 11 via une unique zone continue de la surface 10a de l'élément de report 10 opposée au deuxième capot 5. Cette fixation est réalisée, sur la réalisation non limitative de la figure 3, au moyen d'un unique plot de brasage ou de collage 19 reliant l'élément de report 10 au support 11. Ce mode de réalisation est facile à maitriser. Dans une variante, une pluralité de zones disjointes de l'élément de report 10 sont fixées au support 11. On utilise alors par exemple plusieurs plots de colle ou de brasage. Tout autre mode de fixation permettant de fixer l'empilement au support 11, uniquement via l'élément de report 10 peut être utilisé.

Le support 11 peut être le fond d'un boîtier permettant par exemple d'encapsuler sous vide la puce MEMS. Le support peut en variante être une carte électronique.

Selon l'invention, la couche de découplage 9 comprend un ensemble de structures comprenant l'élément de report 10 et un cadre 12 entourant l'élément de report 10 dans un plan de la couche de découplage perpendiculaire à la direction d'empilement oz. Le plan de la couche de découplage est perpendiculaire au plan de la figure 3, c'est un plan xy. Le cadre 12 entoure de préférence complètement l'élément de report 10. La cadre 12 présente une forme globalement rectangulaire mais toute autre forme est possible. L'élément de report 10 présente une forme de bloc dans le plan xy de la couche de découplage. Autrement dit, la structure de report 10 présente, dans le plan xy de la couche de découplage, la forme d'un ilot monolithique. Par conséquent, la couche de découplage 9 comprend une unique surface 10a par laquelle elle est destinée à être reportée sur un support 11.

L'ensemble de structures comprend une structure de découplage mécanique 13 reliant le cadre 12 à l'élément de report 10. La structure de découplage 13 n'est pas représentée en détails sur la figure 3, elle est représentée par une zone où figurent des points espacés. Elle est disposée autour de l'élément de report 10. La structure de découplage 13 est configurée de sorte à attacher de manière flexible l'élément de report 10 avec le cadre 12 dans le plan xy de la couche de découplage 9. Par conséquent, la structure de découplage 13 permet d'éviter la transmission des déformations statiques du support 11 dans le plan xy vers la structure active 3. Ces déformations dans le plan sont transmises à l'élément de report 10 puis absorbées par la structure de découplage 13. La couche de découplage 13 selon l'invention permet par conséquent d'assurer l'absorption des déformations différentielles du support et de l'élément de report 10 sous l'effet des variations de température tout en permettant d'assurer une fixation rigide de la puce MEMS à un support 11 via l'élément de report 10.

Le cadre 12 est solidaire de la couche de silicium 8 du deuxième capot 5. Les capots 4, 5 et le cadre 12 constituent des zones d'ancrage fixes et solidaires les unes des autres. Selon l'invention, le cadre 12 est fixé directement à la couche de silicium 8 du deuxième capot 5. Par fixée directement, on entend que le cadre 12, est séparé de la couche de silicium 8 au plus par un film 14 d'un matériau, le matériau étant du dioxyde de silicium.

Avantageusement, la couche de découplage 9 est fixée à la couche de silicium 8 uniquement via le cadre 12.

La couche de silicium 8 à laquelle est fixé le cadre 12 est la couche de silicium de l'empilement qui est adjacente à la couche de découplage 9 selon la direction z. Autrement dit, la couche de silicium 8 du deuxième capot 5 est interposée entre la couche de découplage 9 et la couche active 2, selon la direction d'empilement oz sur toute sa surface.

Typiquement, les couches de silicium présentent une épaisseur comprise entre 1 micromètre et 1 mm.

Si, comme c'est le cas sur la figure 2, un film 14 de dioxyde de silicium est interposé entre la couche de silicium 8 et le cadre 12, ce film présente une épaisseur faible par rapport à celle de la couche de découplage 9 et de la couche de silicium 8 du deuxième capot 5. Typiquement, le film 14 de dioxyde de silicium présente une épaisseur comprise entre 10 nanomètres et 2 micromètres. Il présente avantageusement une épaisseur au moins 10 fois plus faible que l'épaisseur de la couche de découplage.

Du fait qu'au plus un film 14 d'oxyde de silicium est interposé entre le cadre 12 de silicium monocristallin et la couche de silicium monocristallin 8 du deuxième capot 5, on limite la transmission des contraintes liées aux déformations thermiques différentielles entre le deuxième capot et la couche de découplage, c'est-à-dire l'effet des variations de température sur la performance de la puce MEMS. En effet, soit les couches de silicium monocristallin sont accolées entre elles, auquel cas la différence de coefficient de dilatation thermique entre ces couches est nulle, soit elles sont séparées uniquement par une couche d'oxyde de silicium dont le coefficient de dilatation thermique est proche de celui du silicium. Il a été démontré expérimentalement que ce type d'empilement, associant du silicium monocristallin et de l'oxyde de silicium, donne de très bons résultats en terme de stabilité en température et dans le temps.

La couche de découplage 9 fixée de la sorte à la couche de silicium 8 du deuxième capot 5 fait partie de la puce MEMS. La puce peut être assemblée en salle blanche et la seule étape de report, qui est une étape critique pour les performances de la puce MEMS, est une étape unique et finale de report de la puce MEMS sur le support par collage ou brasage. Cela permet de limiter l'impact de cette étape critique sur les performances de la puce MEMS et de faciliter sa mise au point et sa maitrise. En effet, la fixation de la couche de découplage à la couche de silicium du deuxième capot sans matériau d'apport autre que le dioxyde de silicium permet d'éviter que le chauffage, lors de l'étape de report de la puce MEMS sur le support, n'ait une influence sur la liaison entre la couche de découplage 9 et le deuxième capot 5. Cela permet également de maîtriser facilement la robustesse de la liaison entre ces couches dans l'environnement applicatif (vibrations, chocs, cycles thermiques) et l'alignement de la structure active et notamment de l'axe sensible du MEMS avec le support et avec la structure de découplage 9 dans le cas d'un capteur inertiel. Par ailleurs, l'étape de fixation de la couche de découplage 9 au deuxième capot 5 peut être réalisée simplement et rapidement de manière collective pour plusieurs puces MEMS par scellement direct ou anodique.

Un autre avantage de l'invention est que la fabrication de la puce MEMS avec sa couche de découplage 9 peut être réalisée par un procédé collectif pour l'ensemble des puces d'un wafer avant séparation des puces. Cela procure un avantage en termes de coût récurrent de fabrication.

Dans un mode privilégié de réalisation de l'invention, la couche de découplage et la couche de silicium 8 sont assemblées par scellement direct aussi appelé scellement par adhésion moléculaire ou adhérence moléculaire ou SDB acronyme de l'expression anglo-saxonne « silicon direct bonding ».

Dans ce type de scellement, on exerce simplement une pression et une température élevées sur les deux wafers de silicium afin de créer des liaisons covalentes au niveau de l'interface de scellement. Ce type de scellement peut être du type hydrophile, c'est-à-dire entre deux surfaces hydrophiles. Dans ce cas, le scellement est réalisé entre deux couches de silicium 8, 12 oxydées, c'est-à-dire présentant un film de SiO₂ en surface. En variante, le scellement hydrophile est réalisé entre une surface de silicium oxydée et une autre surface de silicium non oxydée, c'est-à-dire pure. Dans ces deux cas, un film de SIO2 est alors présent entre ces deux couches dans la puce MEMS finale. L'épaisseur du film de SiO₂ est inférieure ou égale à quelques micromètres. Le scellement direct peut aussi être hydrophobe, c'est-à-dire qu'il est mis en oeuvre entre deux surfaces hydrophobes. Dans ce cas, les deux couches de silicium mises en contact sont pures, c'est-à-dire dépourvues d'un film de SiO₂ en surface. Dans la puce MEMS, ces couches ne sont pas séparées par un film de SiO2, elles sont accolées l'une à l'autre.

Le scellement par adhésion moléculaire permet de limiter la génération de contraintes thermomécaniques à l'interface entre les deux couches de silicium assemblées car elle ne nécessite pas de matériau d'interface autre que le dioxyde de silicium. L'effet du dioxyde de silicium obtenu par oxydation est négligeable car il a un coefficient d'expansion thermique proche de celui du silicium et il peut être réalisé très fin par rapport aux couches de silicium. Le dioxyde de silicium a typiquement une épaisseur inférieure ou égale au dixième de l'épaisseur des couches de silicium. Ceci n'est toutefois pas limitatif.

Dans une variante, les deux couches de silicium sont assemblées par scellement anodique. Ce type d'assemblage nécessite d'interposer une couche de verre contenant des ions sodium ou une couche de dioxyde de silicium riche en ions sodium, entre les deux couches de silicium à assembler. Une couche d'oxyde de silicium sépare les deux couches de silicium dans l'assemblage. Cette couche diffère de la couche d'oxyde de silicium obtenue par scellement direct hydrophile dans la mesure où elle est polluée d'ions sodium. Il est par conséquent possible de distinguer un assemblage obtenu par scellement direct ou par scellement anodique. La microscopie électronique en transmission (TEM) sur une micro-coupe permet d'observer l'empilement de couches, leurs épaisseurs, leurs morphologies et les interfaces. La technique XPS (X-Ray Photoelectron Spectroscopy) pour détecter la présence d'ions sodium dans la couche d'oxyde à l'interface entre les deux couches de silicium assemblées.

Le scellement anodique peut créer des contraintes à l'interface, qui sont associées aux changements physico-chimiques qui interviennent dans le verre durant le scellement et aux différences de coefficients d'expansion thermique entre le verre et le silicium.

Les structures actives et de découplage sont des structures suspendues, c'est-à-dire qu'elles sont déformables dans le plans Oxy.

Sur la réalisation de la figure 3, le deuxième capot 5 comprend deux évidements 17, 18, formés dans la couche de silicium 8 dudit deuxième capot 5. Un premier évidement 17 est en regard de la structure active 3 et un deuxième évidement 18 est en regard de la structure de découplage 13. Ces évidements permettent de garantir un espace entre la structure de découplage et le deuxième capot et entre la structure active et le deuxième capot de manière qu'elles soient suspendues. L'épaisseur de la couche d'oxyde de silicium 16 interposée entre la couche active 2 et la couche de silicium 7 du premier capot 5 est choisie de façon à obtenir une structure active suspendue entre la couche active et la couche de silicium du premier capot. De manière générale, les capots comprennent des évidements en regard de la structure active et/ou de la structure de découplage et/ou une couche de dioxyde de silicium est interposée entre le cadre et les capots adjacents et/ou une couche de le silicium d'au moins un capot et la couche active à l'interface de liaison entre ce capot et la couche active de manière à permettre à la structure active et/ou à la structure de découplage de se déformer librement.

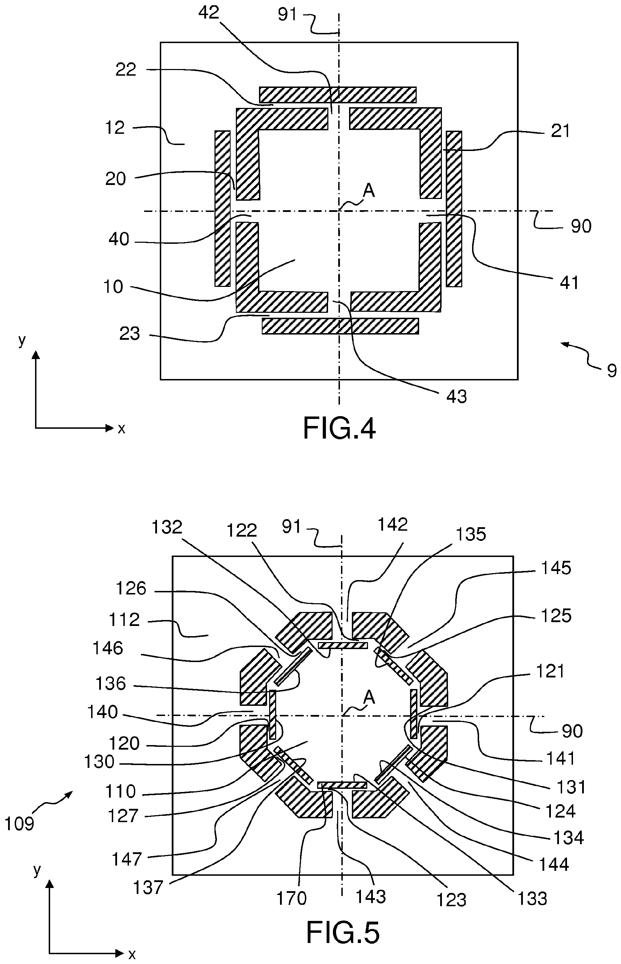

Sur les figures 4 à 5 on a représenté des modes de réalisation de la couche de découplage 9 en coupe dans le plan xy. Le repère Oxyz est orthogonal. Sur ces figures, on a représenté en blanc le silicium et en hachuré les ouvertures réalisées par gravure dans le silicium. Ces modes de réalisation ne sont pas limitatifs, on pourrait envisager d'autres géométries réalisant les mêmes fonctions. Par ailleurs, dans les modes de réalisation représentés, les dimensions (i.e. longueurs, largeurs) des bras ne sont pas limitatives. Ces dimensions ainsi que l'épaisseur de la couche de silicium dans laquelle ils sont réalisées ne sont pas limitatives. Elles sont choisies spécifiquement pour chaque capteur MEMS de façon à obtenir le compromis souhaité entre le découplage statique et le découplage dynamique.

La structure de découplage 13 et l'élément de report central 10 sont formés par micro-usinage dans l'épaisseur de la couche de découplage.

La géométrie et la disposition des structures de découplage relativement au cadre 12 et à l'élément de report central 10 sont définies de façon à filtrer les déformations statiques de la surface de report dans toutes les directions du plan de la couche de découplage et de façon que la partie de la puce MEMS reliée à l'élément de report 10, fixé au support 11, par la structure de découplage 23, présente des modes de vibration de fréquences supérieures aux fréquences des modes utiles de la structure active 3 dans les directions Ox et Oy et autour de l'axe Oz et de préférence dans toutes les directions de l'espace en translation et en rotation. Autrement dit, la structure de découplage 13 est définie de façon à réaliser un découplage des déformations statiques et dynamiques. Autrement dit, lorsque la puce MEMS est fixée sur son support, les contraintes extérieures et les déformations externes ne sont pas transmises aux parties de la puce MEMS séparées de l'élément central de report 10 par les structures de découplage 13. En revanche, une fixation rigide de la puce MEMS sur le support est assurée.

Du fait du découplage dynamique, les fréquences des modes propres de vibration de la puce MEMS fixée sur son support sont bien séparées des fréquences des modes utiles de l'élément sensible. Si cette séparation n'est pas suffisante, il peut se produire un phénomène de couplage entre modes de vibration qui dégrade fortement le facteur de qualité du mode utile et donc la performance du capteur. Par ailleurs, les modes propres de vibration de la puce MEMS fixée sur son support sont peu sensibles à la présence des vibrations dans les environnements opérationnels, de façon à maîtriser les performances, notamment en termes de bruit sur la sortie du capteur.

Sur la réalisation de la figure 4, la structure de découplage 9 reliant l'élément de report central 10 et le cadre 12 comprend ici deux premiers éléments de découplage 20, 21 présentant une faible raideur selon une première direction qui est la direction définie par l'axe Ox sur la figure 3. La première direction Ox est une direction du plan de la couche de découplage Oxy. Les deux premiers éléments de découplage 20, 21 présentent une raideur élevée selon une deuxième direction perpendiculaire à la première direction Ox dans le plan xy, c'est-à-dire selon une direction définie par l'axe Oy sur la figure 1. La première direction définie par l'axe Ox est l'ensemble des droites parallèles à l'axe Ox et la deuxième direction définie par l'axe Oy est l'ensemble des droites parallèles à l'axe Oy. Autrement dit, les premiers éléments de découplage 20, 21 sont conçus pour autoriser un déplacement de l'élément de report central 10 par rapport au cadre 12 selon la première direction Ox mais pour empêcher tout mouvement significatif de l'élément de report central 10 par rapport au cadre 12 selon la deuxième direction Oy.

Ces premiers éléments de découplage sont de préférence situés de part et d'autre de l'élément de report central 10 selon la première direction Ox. Autrement dit un premier élément de découplage 20 est situé d'un côté de l'élément de report central et l'autre premier élément de découplage 21 est situé de l'autre côté de l'élément de report central selon la première direction Ox. Cela permet d'obtenir un bon degré de symétrie ce qui est particulièrement favorable si le MEMS fonctionne avec des structures différentielles puisque cela permet de conserver leurs propriétés.

Il y a alors deux zones d'ancrage sur le cadre 12 situées de part et d'autre de l'élément de report mobile selon la première direction Ox. Les deux premiers éléments de découplage 20, 21 sont de préférence situés de part et d'autre d'un axe de symétrie 91, dans le plan xy, de l'élément de report central 10 parallèle à la deuxième direction Oy.

La structure de découplage comprend en outre deux deuxièmes éléments de découplage 22, 23 présentant une faible raideur selon une troisième direction du plan xy et une raideur élevée selon une quatrième direction perpendiculaire à la troisième direction dans le plan xy. Sur la réalisation de la figure 4, la troisième direction est la direction définie par l'axe Oy et la quatrième direction est la direction définie par l'axe Ox. Autrement dit, les éléments de découplage sont conçus pour autoriser un déplacement de l'élément de report central 10 par rapport au cadre selon la troisième direction Oy mais pour empêcher tout mouvement significatif de l'élément de report central 10 par rapport au cadre 12 selon la quatrième direction Ox. Avantageusement, les raideurs des premiers éléments de découplage dans les directions respectives sont identiques.

Ces deuxièmes éléments de découplage 22, 23 sont de préférence situés de part et d'autre de l'élément de report central 10 selon la troisième direction Oy. Il y a alors deux zones d'ancrage sur le cadre 12 situées de part et d'autre de l'élément de report mobile selon la troisième direction Oy. Avantageusement, ces deuxièmes éléments de découplage 22, 23 sont de préférence situés de part et d'autre d'un axe de symétrie 90, dans le plan xy, de l'élément de report central 10 parallèle à Oy. Il y a alors deux zones d'ancrage sur le cadre 12 situées de part et d'autre de l'élément de report mobile, symétriques par rapport à cet axe de symétrie 90 Avantageusement, les raideurs des deuxièmes éléments de découplage dans les directions respectives sont identiques.

Les éléments de découplage 20 à 23 absorbent les déformations de la surface de report 10a de l'élément de report 10 dans le plan xy qui se traduisent principalement par des déformations des éléments de découplage 20 à 23 selon les directions Ox et Oy mais, du fait de leurs raideurs respectives, ils bloquent les déplacements relatifs entre l'élément de report 10 et le cadre 12. Ainsi, la souplesse des éléments de découplage 20 à 23 permet de transmettre le minimum d'effort sur la structure active 3 pour une déformation statique donnée de l'élément de report central 10. Par contre la combinaison des éléments de découplage raides et souples selon des directions différentes permet de réaliser une fixation très raide de la puce MEMS sur son support. Ainsi, les modes propres de vibration de la puce MEMS (c'est-à-dire de la zone de la puce MEMS reliée à l'élément de report 10 par la structure de découplage 13) dans le plan xy ont des fréquences élevées, c'est-à-dire nettement supérieures aux fréquences des modes utiles de la structure active. Cela permet d'éviter le phénomène de couplage entre le mode de la vibration de la puce MEMS fixée au support et le mode de vibration de la structure active , qui dégraderait fortement le facteur de qualité du mode utile et donc la performance du capteur. Ces deux modes sont découplés quand leurs fréquences respectives sont distinctes.

Sur la réalisation de la figure 4, les premiers éléments de découplage 20 21 sont des bras de flexion. Les premiers bras de flexion 20, 21 sont des bras allongés selon la direction définie par l'axe Oy (direction Oy), de manière à présenter une grande raideur (grande résistance à l'allongement) dans cette direction. Ces bras sont plus précisément allongés selon des axes respectifs distincts parallèles à l'axe Oy. Ils sont très étroits, comparativement à leur longueur, pour présenter une faible raideur dans la direction définie par l'axe Ox (direction Ox), perpendiculaire à la direction Oy. Les deuxièmes éléments de découplage 22, 23 sont des bras de flexion. Les deuxièmes bras de flexion 22, 23 sont des bras allongés selon la direction Ox, de manière à présenter une grande raideur (grande résistance à l'allongement) dans cette direction. Ils sont très étroits, comparativement à leur longueur, pour présenter une faible raideur dans la direction Oy, perpendiculaire à Ox. Cette configuration est compacte, simple à réaliser et à régler. En variante, les éléments de découplage peuvent présenter toute autre forme présentant une raideur importante selon une direction et une raideur comparativement faible selon une direction perpendiculaire à ladite direction.

On peut envisager un nombre différent, supérieur ou inférieur, d'éléments de découplage. De manière générale, la structure de découplage comprend au moins un premier élément de découplage présentant une faible raideur selon une première direction du plan xy et une forte raideur selon une deuxième direction du plan xy perpendiculaire à la première direction et un deuxième élément de découplage présentant une faible raideur selon une troisième direction du plan xy et une forte raideur selon une quatrième direction du plan xy , la première et la troisième direction étant différentes. Cela permet d'assurer une fixation rigide en translation dans le plan xy et en rotation autour de l'axe z.

Avantageusement, comme cela est représenté sur la figure 4, la première et la troisième direction sont orthogonales. Ce mode de réalisation permet de limiter le mouvement de la partie suspendue de la puce MEMS en présence de vibrations ou d'accélérations appliquées à l'élément de report 10.

Sur la figure 4, l'élément de report central présente une forme carrée présentant deux axes de symétrie 90, 91 dans le plan xy. Il est relié à des éléments 20, 21, 22, 23 de découplage au moyen de bras rigides respectifs 40 à 43, c'est-à-dire présentant une grande raideur selon les directions Ox et Oy.

Un deuxième exemple de couche de découplage est représenté en coupe sur la figure 5. Dans cet exemple, la couche de découplage 109 diffère de la couche de découplage de la figure 4 en ce qu'elle comprend un élément de report 110 délimité par un octogone 170. Cet octogone 170 présente quatre axes de symétrie. L'élément de report 110 est relié au cadre 112 par des éléments de découplage 120 à 127 reliant les côtés respectifs 130 à 137 de l'octogone au cadre 112 et réalisés sous forme de bras de flexion allongés s'étendant respectivement parallèlement aux côtés 130 à 137 respectifs de l'octogone. Les éléments de découplage 120 à 127 sont reliés à l'élément de report 110 via des bras rigides respectifs. Le plus grande nombre d'axes de symétrie dans le plan xy permet d'obtenir une meilleure isotropie des contraintes statiques transmises du support à la puce MEMS.

De manière générale, l'élément de report central 10 est avantageusement délimité par une forme globale de polygone. Avantageusement, la structure de découplage comprend une pluralité d'éléments de liaison 120 à 127 et 140 à 147, chaque élément de liaison comprenant au moins un desdits bras de liaison 120 à 127 s'étendant parallèlement audit côté 130 à 137 du polygone. Cette configuration est particulièrement avantageuse car elle est peu volumineuse.

Avantageusement, le polygone est un polygone à N côtés et structure de découplage comprend N éléments de liaison comprenant un premier jeu de N bras de flexion s'étendant longitudinalement parallèlement aux N côtés respectifs du polygone. Avantageusement le polygone est régulier et présente un nombre de côtés pair, par exemple un carré. Avantageusement, le polygone présente plus de quatre côtés.

Sur les modes de réalisation de la figure 4 les bras sont situés à l'intérieur du polygone (carré) et sur le mode de réalisation de la figure 5, les bras sont situés à l'extérieur du polygone. Dans une variante non représentée, la structure de découplage comprend deux jeux de bras situés à l'intérieur et respectivement à l'extérieur du polygone.

Avantageusement, les éléments de découplage sont conçus de façon à ne pas permettre de mouvement significatif du cadre 10 par rapport à l'élément de report 9 selon l'axe z. Cela est obtenu par une épaisseur suffisante des éléments de découplage selon l'axe z. Cette raideur permet d'éviter les mouvements du cadre 10, par rapport à l'élément de report 9, en rotation autour des axes x et y et en translation selon l'axe z.

Les modes de réalisation des figures 4 à 5 ne sont pas limitatifs, la configuration de la structure de découplages est choisie en fonction de la structure de la structure sensible et des performances souhaitées en termes de découplage.

Le nombre, la géométrie et l'orientation des éléments de découplage sont de préférence choisis en fonction de la symétrie de la structure de découplage. Avantageusement, si la structure active présente un (ou des) élément(s) de symétrie dans le plan perpendiculaire à la direction d'empilement, la structure de découplage présente le(s) même(s) élément(s) de symétrie que la structure active. Avantageusement, l'élément de report présente aussi le ou les mêmes éléments de symétrie. Cela permet d'éviter toute anisotropie des phénomènes physiques transmis à l'élément sensible et de minimiser l'excitation des modes de la fixation ayant une composante de mouvement en rotation dans le plan perpendiculaire à la direction d'empilement.

Avantageusement, la structure active présente au moins deux plans de symétrie perpendiculaires entre eux et parallèles à la direction d'empilement Oz, la structure de fixation est configurée et agencée de manière à être symétrique par rapport aux deux plans de symétrie. Cette configuration permet de conserver la symétrie générale de la structure de la puce MEMS qui permet d'assurer la symétrie des effets physiques s'appliquant sur la structure sensible. Ceci est particulièrement important dans le cas où la structure sensible est réalisée avec une structure différentielle, comme c'est fréquemment le cas dans les capteurs MEMS les plus performants.

Avantageusement, l'élément de report et la structure de découplage présentent des plans de symétrie parallèles à la direction d'empilement, ces plans de symétrie se coupent selon une droite qui est parallèle à la direction d'empilement et sur laquelle est situé le centre de masse de la partie de la puce MEMS qui est reliée à l'élément de report par la structure de découplage. Cette partie de la puce MEMS est formée par le cadre, le premier et le deuxième capots et la couche active. Autrement dit, les coordonnées du centre de masse de la partie de la puce MEMS qui est reliée à l'élément de report par la structure de découplage dans un plan perpendiculaire à la direction d'empilement sont les mêmes que celles de la droite selon laquelle se croisent les plans de symétrie de la structure de découplage. Ces coordonnées sont les coordonnées du point A dans l'exemple de la figure 4. Cette configuration permet d'équilibrer la structure pour limiter l'effet des vibrations. Elle permet d'éviter que la partie de la puce MEMS qui est reliée à l'élément de report par la structure de découplage ne pivote par rapport à la structure de découplage autour des axes ox et oy.

L'invention se rapporte également à un procédé de fabrication d'un microsystème électromécanique selon l'invention.

Le procédé comprend une étape de formation de l'assemblage de la pluralité de couches comprenant une étape de formation des couches divisée en sous-étapes relatives aux différentes couches, une étape d'empilement et d'assemblage des différentes couches éventuellement divisée en étapes individuelles d'empilement et d'assemblage de pluralité de couches prises parmi les couches destinées à former l'empilement.

Selon l'invention, le procédé l'étape d'empilement et d'assemblage comprend une étape individuelle d'empilement et d'assemblage de la couche de découplage 9 et de la couche de silicium 8 du deuxième capot de protection 5, de sorte qu'au plus un film 14 d'un matériau est interposé entre la couche de découplage 9 et ladite couche de silicium 8, le matériau étant du dioxyde de silicium.

Avantageusement, comme cela est précisé précédemment, l'étape individuelle d'empilement et d'assemblage de la couche de découplage 9 et de la couche de silicium 8 du deuxième capot de protection 5 est une étape de scellement direct. En variante, cette étape est une étape de scellement anodique.

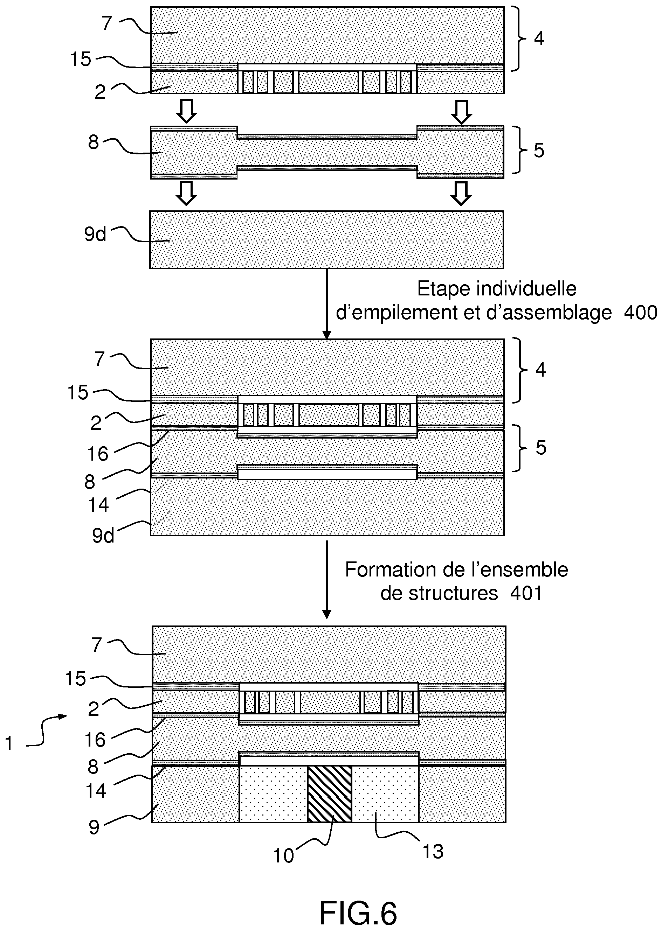

Un exemple de procédé de fabrication selon l'invention est représenté sur la figure 6.

Les structures actives et les ensembles de structures sont obtenues par micro-usinage.

L'usinage de la structure active peut être réalisé en utilisant comme substrat d'origine un substrat de silicium sur isolant, mais d'autres méthodes sont également possibles. Un substrat en silicium sur isolant est constitué d'un substrat de silicium de quelques centaines de micromètres d'épaisseur qui porte sur sa face avant une fine couche d'oxyde de silicium elle-même recouverte d'une couche de silicium monocristallin de quelques dizaines de micromètres d'épaisseur. L'usinage consiste à attaquer le silicium de la couche supérieure par sa face avant, selon les motifs de surface désirés, au moyen de techniques de photogravure en usage en microélectronique, jusqu'à atteindre la couche d'oxyde, avec un produit de gravure sélectif qui attaque le silicium sans attaquer significativement l'oxyde. On arrête la gravure lorsque la couche d'oxyde est mise à nu. Cette couche d'oxyde est ensuite enlevée par attaque sélective avec un autre produit de manière à ne conserver que la couche superficielle de silicium monocristallin, sauf à l'endroit des zones d'ancrage où la couche d'oxyde subsiste et forme une liaison solidaire entre le substrat et la couche superficielle de silicium monocristallin (la couche active). L'usinage par la face avant définit les différents découpages des parties mobiles.

On obtient un wafer (ou plaque) appelé wafer structure active constitué d'un assemblage du premier capot et de la couche active.

Sur la réalisation de la figure 6, le procédé comprend :
- une étape individuelle d'empilement et d'assemblage 400 du wafer structure active 4, 15, 2 obtenu, du deuxième capot 5 et d'une couche de silicium monocristallin 9d, destinée à former la couche de découplage, l'assemblage étant réalisé de préférence par scellement direct, cette étape étant l'étape d'assemblage de la couche de découplage et de la couche de silicium du deuxième capot,
- suivie d'une étape 401 de formation de l'ensemble de structures dans la couche 9d de silicium destinée à former la couche de découplage de sorte obtenir la couche de découplage.

L'étape 401 de formation de l'ensemble de structures est donc ultérieure à l'étape individuelled'empilement et d'assemblage 400 de la couche de découplage et de la couche de silicium du deuxième capot. En variante, l'étape de formation de l'ensemble de structures pourrait être antérieure à l'étape d'assemblage de la couche de découplage et de la couche de silicium du deuxième capot.

Sur la réalisation non limitative de la figure 6, la couche de silicium du deuxième capot est oxydée préalablement à l'étape d'assemblage avec la couche 9d.

L'étape de formation de l'ensemble de structures est aussi une étape d'usinage telle que décrite pour la réalisation de la structure active. De préférence, l'étape de formation de la structure de découplage comprend une étape de gravure ionique réactive profonde (en anglais « Deep Reactive Ion Etching » ou DRIE). Ce type de gravure est préféré pour sa précision et pour la bonne verticalité des flancs des ouvertures, mais une gravure par attaque chimique par voie humide (e.g. avec de l'hydroxyde de potassium, KOH) peut aussi être envisagée. L'éventuelle couche d'oxyde de silicium séparant le deuxième capot et la couche de silicium destinée à former la structure de découplage ou découpleur mécanique sert de couche d'arrêt pour la gravure.

Dans une variante non représentée, le procédé comprend :
- une étape de formation de la structure active dans un premier substrat de silicium sur isolant,
- une étape individuelle d'empilement et d'assemblage du wafer (plaque) structure active obtenu lors de l'étape précédente, et d'un deuxième substrat de silicium sur isolant en regard de la couche active , le deuxième substrat de silicium sur isolant comprenant une première couche de silicium en regard de la couche active et une deuxième couche de silicium destinée à former la couche de découplage, l'assemblage est avantageusement mis en oeuvre par scellement par adhésion moléculaire,
- suivie d'une étape de formation de l'ensemble de structures dans la couche de silicium destinée à former la couche de découplage.

Dans une autre variante non représentée, l'ensemble de structures est réalisé dans un double substrat de silicium sur isolant comprenant un empilement d'une couche de substrat silicium destinée à former la couche de découplage et de deux autres couches de silicium, l'une destinée à former la couche de silicium du deuxième capot et l'autre destinée à former la couche active. Cette étape est suivie d'une étape d'empilement du double substrat de silicium sur isolant obtenu avec le premier capot et d'assemblage par scellement par adhésion moléculaire. L'étape individuelle d'assemblage de la couche de découplage et de la couche de silicium du deuxième capot de protection est réalisée lors de la fabrication du double substrat de silicium sur isolant.

Les modes de réalisation décrits précédemment sont des exemples de réalisation non limitatifs.

Avantageusement, l'étape de formation de l'assemblage de la pluralité de couches est collective. Elle permet d'obtenir un assemblage sous forme d'une plaque intégrant une pluralité de microsystèmes électromécaniques selon l'invention dont les couches respectives sont communes à tous les microsystèmes électromécaniques. Les couches comprennent une couche active comprenant une pluralité de structures actives, une première couche capot comprenant une pluralité de premiers capots, une deuxième couche capot comprenant une pluralité de deuxièmes capots et une couche de découplage comprenant une pluralité d'ensembles de structures. Autrement dit les étapes individuelles d'empilement et d'assemblage sont communes à tous les microsystèmes.

Le procédé de fabrication comprend une étape de séparation consistant à découper la plaque de sorte à isoler les microsystèmes selon l'invention, c'est-à-dire à les séparer les uns des autres.

Le procédé de fabrication du dispositif électromécanique selon l'invention comprend le procédé décrit précédemment et une étape de report de la puce MEMS, c'est-à-dire du microsystème électromécanique, sur le support de façon que la puce MEMS soit fixée au support via l'élément de report central. Autrement dit, seul l'élément de report de la couche de découplage est fixé au support. Cette étape peut être réalisée par brasage ou collage ou par tout autre moyen de fixation. Cette étape est réalisée individuellement pour chaque puce MEMS, c'est-à-dire après l'étape de séparation.

## Revendications

1. Microsystème électromécanique (1) comprenant un assemblage (1e) d'une pluralité de couches empilées selon une direction d'empilement (z) comprenant :
- une couche active (2) en silicium monocristallin, ladite couche active (2) comprenant une structure active (3),
- un premier capot (4) et un deuxième capot (5) délimitant une cavité (6) autour de la structure active (3), la couche active (2) étant interposée entre le premier capot (4) et le deuxième capot (5), le deuxième capot (5) comprenant une unique couche (8) en silicium monocristallin,
**caractérisé en ce que** l'assemblage (1e) comprend en outre, une couche de découplage (9) en silicium monocristallin comprenant :
- un élément de report (10) destiné à être fixé à un support (11),
- un cadre (12) entourant l'élément de report (10) dans le plan de la couche de découplage (9),
- une structure de découplage mécanique (13) reliant le cadre (12) et l'élément de report (10), la structure de découpage mécanique (13) permettant de relier de façon flexible l'élément de report (10) au cadre (12),
**en ce que** le cadre (12) est solidaire de la couche de silicium (8) du deuxième capot (5) et **en ce qu'**au plus un film d'un matériau est interposé entre ledit cadre (12) et ladite couche de silicium (8) du deuxième capot (5), le matériau étant du dioxyde de silicium.

2. Microsystème électromécanique selon la revendication précédente, dans lequel la couche de découplage (9) et le deuxième capot (5) sont assemblés par scellement direct.

3. Microsystème électromécanique selon l'une quelconque des revendications précédentes, dans lequel la forme de la structure active (3) dans un plan perpendiculaire à la direction d'empilement présente au moins un élément de symétrie et dans lequel la structure de découplage mécanique présente ledit au moins un élément de symétrie.

4. Microsystème électromécanique selon l'une quelconque des revendications précédentes, dans lequel l'élément de report et la structure de découplage présentent des plans de symétrie parallèles à la direction d'empilement, ces plans de symétrie se coupent selon une droite qui est parallèle à la direction d'empilement et sur laquelle est situé le centre de masse de la partie du microsystème électromécanique qui est reliée à l'élément de report par la structure de découplage.

5. Microsystème électromécanique selon l'une quelconque des revendications précédentes, dans lequel la structure de découplage mécanique (13) comprend :
- au moins un premier élément de découplage conçu pour autoriser un déplacement de l'élément de report (10) par rapport au cadre (12) selon une première direction (Ox) du plan de la couche de découplage mais pour empêcher tout mouvement significatif de l'élément de report (10) par rapport au cadre (12) selon un deuxième direction (Oy) du plan de la couche de découplage perpendiculaire à la première direction (Ox),
- au moins un deuxième élément de découplage conçu pour autoriser un déplacement de l'élément de report (10) par rapport au cadre (12) selon une troisième direction (Oy) du plan de la couche de découplage mais pour empêcher tout mouvement significatif de l'élément de report (10) par rapport au cadre (12) selon une quatrième direction (Ox) du plan de la couche de découplage perpendiculaire à la troisième direction (Oy), la troisième direction (Oy) étant distincte de la première direction (Ox).

6. Microsystème électromécanique selon la revendication précédente, dans lequel la première direction (Ox) et la troisième direction (Oy) sont orthogonales.

7. Microsystème électromécanique selon la revendication précédente, dans lequel la structure de découplage mécanique (13) comprend deux premiers éléments de découplage (20, 21), disposés de part et d'autre l'élément de report (10) selon la première direction (Ox) et deux deuxièmes éléments de découplage disposés de part et d'autre de l'élément de report (10) selon la troisième direction (Oy).

8. Microsystème électromécanique selon l'une quelconque des revendications 5 à 7, dans lequel les premiers et deuxièmes éléments de découplage sont des bras de flexion.

9. Microsystème électromécanique selon la revendication précédente, dans lequel l'élément de report central (10) est délimité par un polygone comprenant une pluralité de côtés, la structure de découplage (13) comprenant des éléments de liaison reliant le cadre (12) et les côtés respectifs du polygone, chaque élément de liaison comprenant au moins un desdits bras de liaison s'étendant parallèlement audit côté du polygone.

10. Microsystème électromécanique selon la revendication précédente, dans lequel le polygone comprend plus de quatre côtés.

11. Dispositif électromécanique comprenant le microsystème électromécanique selon l'une quelconque des revendications précédentes et un support (11), la couche de découplage étant fixée audit support (11) uniquement via ledit élément de report (10).

12. Dispositif électromécanique selon la revendication précédente, dans lequel une unique surface continue de l'élément de report (10) est fixée audit support (11).

13. Procédé de fabrication d'un microsystème électromécanique selon l'une quelconque des revendications précédentes, ledit procédé comprenant une étape de formation de l'assemblage comprenant une étape d'empilement et d'assemblage (400) dans laquelle on empile et on assemble la couche de découplage (9) et la couche de silicium (8) du deuxième capot (5), de sorte qu'au plus un film (14) d'un matériau est interposé entre la couche de découplage et ladite couche de silicium (8) du deuxième capot (5), le matériau étant du dioxyde de silicium.

14. Procédé de fabrication selon la revendication précédente, dans lequel l'assemblage de la couche de découplage (9) et de la couche de silicium (8) du deuxième capot (5) est réalisé par scellement direct.

15. Procédé de fabrication selon l'une quelconque des revendications 13 à 14, comprenant une étape collective de formation de l'assemblage de la pluralité de couches permettant d'obtenir un assemblage sous forme d'une plaque intégrant une pluralité de microsystèmes électromécaniques et une étape de séparation consistant à découper la plaque de sorte à isoler les microsystèmes électromécaniques.

## Patentansprüche

1. Elektromechanisches Mikrosystem (1), das eine Baugruppe (1e) aus mehreren Schichten umfasst, die in einer Stapelrichtung (z) gestapelt sind, das Folgendes umfasst:
- eine aktive Schicht (2) aus monokristallinem Silicium, wobei die aktive Schicht (2) eine aktive Struktur (3) umfasst,
- eine erste Abdeckkappe (4) und eine zweite Abdeckkappe (5), die einen Hohlraum (6) um die aktive Schicht (3) begrenzen, wobei die aktive Schicht (2) zwischen der ersten Abdeckkappe (4) und der zweiten Abdeckkappe (5) angeordnet ist, wobei die zweite Abdeckkappe (5) eine einzige Schicht (8) aus monokristallinem Silicium umfasst,
**dadurch gekennzeichnet, dass** die Baugruppe (1e) ferner eine Entkopplungsschicht (9) aus monokristallinem Silicium umfasst, die Folgendes umfasst:
- ein Übertragselement (10) zum Fixieren an einem Substrat (11),
- einen Rahmen (12), der das Übertragselement (10) in der Ebene der Entkopplungsschicht (9) umgibt,
- eine mechanische Entkopplungsstruktur (13), die den Rahmen (12) und das Übertragselement (10) verbindet, wobei die mechanische Entkopplungsschicht (13) eine flexible Verbindung des Übertragselements (10) mit dem Rahmen (12) zulässt,
dadurch, dass der Rahmen (12) einstückig mit der Siliciumschicht (8) der zweiten Abdeckkappe (5) verbunden ist, und dadurch, dass höchstens ein Film aus einem Material zwischen dem Rahmen (12) und der Siliciumschicht (8) der zweiten Abdeckkappe (5) angeordnet ist, wobei das Material Siliciumdioxid ist.

2. Elektromechanisches Mikrosystem nach dem vorherigen Anspruch, bei dem die Entkopplungsschicht (9) und die zweite Abdeckkappe (5) durch Direktverguss zusammengefügt werden.

3. Elektromechanisches Mikrosystem nach einem der vorherigen Ansprüche, wobei die Form der aktiven Struktur (3) in einer Ebene lotrecht zur Stapelungsrichtung wenigstens ein Symmetrieelement ergibt und wobei die mechanische Entkopplungsstruktur das wenigstens eine Symmetrieelement aufweist.

4. Elektromechanisches Mikrosystem nach einem der vorherigen Ansprüche, bei dem das Übertragselement und die Entkopplungsstruktur Symmetrieebenen parallel zur Stapelungsrichtung aufweisen, wobei diese Symmetrieebenen sich entlang einer Geraden schneiden, die parallel zur Stapelungsrichtung ist und auf der sich der Massenschwerpunkt des Teils des elektromechanischen Mikrosystems befindet, der mit dem Übertragselement durch die Entkopplungsstruktur verbunden ist.

5. Elektromechanisches Mikrosystem nach einem der vorherigen Ansprüche, wobei die mechanische Entkopplungsstruktur (13) Folgendes umfasst:
- wenigstens ein erstes Entkopplungselement, vorgesehen zum Zulassen einer Verschiebung des Übertragselements (10) relativ zum Rahmen (12) in einer ersten Richtung (Ox) der Ebene der Entkopplungsschicht, aber zum Verhindern jeder signifikanten Bewegung des Übertragselements (10) relativ zum Rahmen (12) in einer zweiten Richtung (Oy) der Ebene der Entkopplungsschicht lotrecht zur ersten Richtung (Ox),
- wenigstens ein zweites Entkopplungselement, vorgesehen zum Zulassen einer Verschiebung des Übertragselements (10) relativ zum Rahmen (12) in einer dritten Richtung (Oy) der Ebene der Entkopplungsschicht, aber zum Verhindern jeder signifikanten Bewegung des Übertragselements (10) relativ zum Rahmen (12) in einer vierten Richtung (Ox) der Ebene der Entkopplungsschicht lotrecht zur dritten Richtung (Oy), wobei die dritte Richtung (Oy) sich von der ersten Richtung (Ox) unterscheidet.

6. Elektromechanisches Mikrosystem nach dem vorherigen Anspruch, wobei die erste Richtung (Ox) und die dritte Richtung (Oy) orthogonal sind.

7. Elektromechanisches Mikrosystem nach dem vorherigen Anspruch, wobei die mechanische Entkopplungsstruktur (13) zwei erste Entkopplungselemente (20, 21) umfasst, die auf beiden Seiten des Übertragselements (10) in der ersten Richtung (Ox) angeordnet sind, und zwei zweite Entkopplungselemente, die auf beiden Seiten des Übertragselements (10) in der dritten Richtung (Oy) angeordnet sind.

8. Elektromechanisches Mikrosystem nach einem der Ansprüche 5 bis 7, wobei die ersten und die zweiten Entkopplungselemente Biegungsarme sind.

9. Elektromechanisches Mikrosystem nach dem vorherigen Anspruch, wobei das zentrale Übertragselement (10) durch ein Polygon begrenzt wird, das mehrere Seiten hat, wobei die Entkopplungsstruktur (13) Verbindungselemente umfasst, die den Rahmen (12) und die jeweiligen Seiten des Polygons verbinden, wobei jedes Verbindungselement wenigstens einen der Verbindungsarme umfasst, die parallel zu der Seite des Polygons verlaufen.

10. Elektromechanisches Mikrosystem nach dem vorherigen Anspruch, wobei das Polygon mehr als vier Seiten aufweist.

11. Elektromechanische Vorrichtung, die das elektromechanische Mikrosystem nach einem der vorherigen Ansprüche und ein Substrat (11) umfasst, wobei die Entkopplungsschicht nur über das Übertragselement (10) am Substrat (11) befestigt ist.

12. Elektromechanische Vorrichtung nach dem vorherigen Anspruch, wobei eine einzige kontinuierliche Fläche des Übertragselements (10) am Substrat (11) befestigt ist.

13. Verfahren zur Herstellung eines elektromechanischen Mikrosystems nach einem der vorherigen Ansprüche, wobei das Verfahren einen Schritt des Bildens der Baugruppe beinhaltet, der einen Schritt des Stapelns und des Zusammenfügens (400) beinhaltet, in dem die Entkopplungsschicht (9) und die Siliciumschicht (8) der zweiten Abdeckkappe (5) gestapelt und zusammengefügt werden, so dass höchstens ein Film (14) aus einem Material zwischen der Entkopplungsschicht und der Siliciumschicht (8) der zweiten Abdeckkappe (5) angeordnet wird, wobei das Material Siliciumdioxid ist.

14. Verfahren zur Herstellung nach dem vorherigen Anspruch, wobei das Zusammenfügen der Entkopplungsschicht (9) und der Siliciumschicht (8) der zweiten Abdeckkappe (5) durch Direktverguss erfolgt.

15. Verfahren zur Herstellung nach einem der Ansprüche 13 bis 14, das einen kollektiven Schritt des Bildens der Baugruppe der mehreren Schichten, so dass eine Baugruppe in Form einer Platte erhalten werden kann, die mehrere elektromechanische Mikrosysteme integriert, und einen Schritt des Abtrennens bestehend aus dem Schneiden der Platte beinhaltet, um die elektromechanischen Mikrosysteme zu isolieren.

## Claims

1. A microelectromechanical system (1) comprising an assembly (1e) of a plurality of layers stacked in a stacking direction (z) comprising:
- an active layer (2) made of monocrystalline silicon, said active layer (2) comprising an active structure (3),
- a first cover (4) and a second cover (5) delimiting a cavity (6) around the active structure (3), the active layer (2) being interposed between the first cover (4) and the second cover (5), the second cover (5) comprising a single layer (8) made of monocrystalline silicon,
**characterised in that** the assembly (1e) further comprises a decoupling layer (9) made of monocrystalline silicon comprising:
- an attaching element (10) intended to be fixed to a support (11),
- a frame (12) surrounding the attaching element (10) in the plane of the decoupling layer (9),
- a mechanical decoupling structure (13) connecting the frame (12) and the attaching element (10), the mechanical decoupling structure (13) allowing the attaching element (10) to be joined flexibly to the frame (12),
**in that** the frame (12) is secured to the silicon layer (8) of the second cover (5), and **in that** at most, one film of a material is interposed between said frame (12) and said silicon layer (8) of the second cover (5), the material being silicon dioxide.

2. The microelectromechanical system according to the preceding claim, wherein the decoupling layer (9) and the second cover (5) are assembled by direct sealing.

3. The microelectromechanical system according to any of the preceding claims, wherein the form of the active structure (3) in a plane perpendicular to the stacking direction has at least one symmetry element, and wherein the mechanical decoupling structure has said at least one symmetry element.

4. The microelectromechanical system according to any of the preceding claims, wherein the attaching element and the decoupling structure have planes of symmetry parallel to the stacking direction, these planes of symmetry intersecting along a straight line that is parallel to the stacking direction and on which is located the centre of mass of the part of the microelectromechanical system which is connected to the attaching element by the decoupling structure.

5. The microelectromechanical system according to any of the preceding claims, wherein the mechanical decoupling structure (13) comprises:
- at least one first decoupling element designed to permit movement of the attaching element (10) with respect to the frame (12) in a first direction (Ox) of the plane of the decoupling layer, but to prevent any significant movement of the attaching element (10) with respect to the frame (12) in a second direction (Oy) of the plane of the decoupling layer perpendicular to the first direction (Ox),
- at least one second decoupling element designed to permit a movement of the attaching element (10) with respect to the frame (12) in a third direction (Oy) of the plane of the decoupling layer, but to prevent any significant movement of the attaching element (10) with respect to the frame (12) in a fourth direction (Ox) of the plane of the decoupling layer perpendicular to the third direction (Oy), the third direction (Oy) being distinct from the first direction (Ox).

6. The microelectromechanical system according to the preceding claim, wherein the first direction (Ox) and the third direction (Oy) are orthogonal.

7. The microelectromechanical system according to the preceding claim, wherein the mechanical decoupling structure (13) comprises two first decoupling elements (20, 21) which are placed on either side of the attaching element (10) in the first direction (Ox) and two second decoupling elements placed on either side of the attaching element (10) in the third direction (Oy).

8. The microelectromechanical system according to any of Claims 5 to 7, wherein the first and second decoupling elements are flexure arms.

9. The microelectromechanical system according to the preceding claim, wherein the central attaching element (10) is delimited by a polygon that has a plurality of sides, the decoupling structure (13) comprising joining elements joining the frame (12) and the respective sides of the polygon, each joining element comprising at least one of said joining arms extending parallel to said side of the polygon.

10. The microelectromechanical system according to the preceding claim, wherein the polygon has more than four sides.

11. An electromechanical device comprising the microelectromechanical system according to any of the preceding claims and a support (11), the decoupling layer being fixed to said support (11) purely via said attaching element (10).

12. The electromechanical device according to the preceding claim, wherein a single continuous surface of the attaching element (10) is fixed to said support (11).

13. A process for producing a microelectromechanical system according to any of the preceding claims, said process comprising a step of forming the assembly comprising a stacking and assembling step (400) in which the decoupling layer (9) and the silicion layer (8) of the second cover (5) are stacked and assembled such that at most one film (14) of a material is interposed between the decoupling layer and said silicon layer (8) of the second cover (5), the material being silicon dioxide.

14. The production process according to the preceding claim, wherein the decoupling layer (9) and the silicon layer (8) of the second cover (5) are assembled by direct sealing.

15. The production process according to either of Claims 13 to 14, comprising a collective step of forming the assembly of the plurality of layers that makes it possible to obtain an assembly in the form of a plate integrating a plurality of microelectromechanical systems and a separating step consisting in cutting up the plate such as to isolate the microelectromechanical systems.
